# EUROPEAN PATENT APPLICATION

(11) **EP 4 637 175 A1**
(43) Date of publication of application: **22.10.2025**
(21) Application number: 25157407.5
(22) Date of filing: 12.02.2025
(51) Int. Cl.: H04N 25/616, H04N 25/76, H04N 25/778, H10F 39/00

(54) **IMAGE SENSING DEVICE**

(30) Priority: 15.04.2024 KR 20240049840
(71) Applicant: SK hynix Inc., Bubal-eub Icheon-si Gyeonggi-do 17336 (KR)
(72) Inventor: KIM, Jong Eun, 17336 Icheon-si, Gyeonggi-do (KR); KIM, Kyung Do, 17336 Icheon-si, Gyeonggi-do (KR); YOON, Hyung June, 17336 Icheon-si, Gyeonggi-do (KR); LEE, Su Hyeon, 17336 Icheon-si, Gyeonggi-do (KR); JANG, Jae Hyung, 17336 Icheon-si, Gyeonggi-do (KR); CHOI, Hoon Moo, 17336 Icheon-si, Gyeonggi-do (KR)
(74) Representative: Isarpatent

(57) **Abstract**

In an embodiment, an image sensing device includes a photoelectric conversion element configured to generate photocharges by converting incident light; a transfer transistor configured to transfer, to a floating diffusion node, the photocharges generated by the photoelectric conversion element, based on a transfer signal; a reset transistor configured to reset the floating diffusion node based on a reset signal; a first pixel signal output unit configured to output a first pixel signal based on a first reference voltage and a voltage of the floating diffusion node in a situation where the floating diffusion node is reset by the reset transistor; and a second pixel signal output unit configured to output a second pixel signal based on the voltage of the floating diffusion node and a second reference voltage in a situation where the voltage of the floating diffusion node is altered by the photocharges generated by the photoelectric conversion element.

## Description

### TECHNICAL FIELD

The technology and implementations disclosed in this patent document generally relate to an image sensing device.

### BACKGROUND

Image sensors are used in electronic devices to convert optical images into electrical signals. With the recent development of automotive, medical, computer and communication industries, the demand for highly integrated, higher-performance image sensors has been rapidly increasing in various electronic devices such as digital cameras, camcorders, personal communication systems (PCSs), video game consoles, surveillance cameras, medical micro-cameras, robots, etc.

### SUMMARY

Various embodiments of the disclosed technology relate to an image sensing device capable of widely expanding the operating range of a unit pixel.

In an embodiment of the disclosed technology, an image sensing device may include a photoelectric conversion element configured to generate photocharges by converting incident light; a floating diffusion node located adjacent to the photoelectric conversion element and configured to receive and store the photocharges generated by the photoelectric conversion element; a transfer transistor coupled to the photoelectric conversion element and floating diffusion node and configured to transfer, in response to a transfer signal, the photocharges generated by the photoelectric conversion element to the floating diffusion node; a reset transistor coupled to the floating diffusion node and configured to reset the floating diffusion node based on a reset signal; a first pixel signal output unit coupled to the floating diffusion node and configured to output a first pixel signal based on a first reference voltage and a voltage of the floating diffusion node in response to reset of the floating diffusion node by the reset transistor; and a second pixel signal output unit coupled to the floating diffusion node and configured to output a second pixel signal based on the voltage of the floating diffusion node and a second reference voltage having a different voltage level from the first reference voltage in response to a change of the voltage of the floating diffusion node due to reception of the photocharges from the photoelectric conversion element.

In another embodiment of the disclosed technology, an image sensing device may include a first sub-pixel block including: a first floating diffusion node; and a plurality of first unit pixels configured to share the first floating diffusion node; a second sub-pixel block including: a second floating diffusion node connected to the first floating diffusion node to form a common floating diffusion node; and a plurality of second unit pixels configured to share the second floating diffusion node; a reset transistor coupled to the common floating diffusion node and configured to reset the common floating diffusion node based on a reset signal; a first pixel signal output unit coupled to the common floating diffusion node and configured to output a first pixel signal based on a first reference voltage and a voltage of the common floating diffusion node in a situation where the common floating diffusion node is reset by the reset transistor; and a second pixel signal output unit coupled to the common floating diffusion node and configured to output a second pixel signal based on the voltage of the common floating diffusion node and a second reference voltage having a different voltage level from the first reference voltage in a situation where the voltage of the common floating diffusion node is altered by photocharges generated by the photoelectric conversion element.

It is to be understood that both the foregoing general description and the following detailed description of the disclosed technology are illustrative and explanatory and are intended to provide further explanation of the disclosure as claimed.

### BRIEF DESCRIPTION OF THE DRAWINGS

The above and other features and beneficial aspects of the disclosed technology will become readily apparent with reference to the following detailed description when considered in conjunction with the accompanying drawings.
FIG. 1 is a block diagram illustrating an example of an image sensing device based on some implementations of the disclosed technology.
FIG. 2 is a circuit diagram illustrating an example of a unit pixel formed in a pixel region shown in FIG. 1 based on some implementations of the disclosed technology.
FIG. 3 is a timing diagram illustrating example operations of pixel transistors shown in FIG. 2 based on some implementations of the disclosed technology.
FIG. 4 is a diagram illustrating the effects when the operating range of the unit pixel is expanded operating range based on some implementations of the disclosed technology.
FIG. 5 is a plan view illustrating an example of the actual layout of the circuit elements of FIG. 2 within the unit pixel based on some implementations of the disclosed technology.
FIG. 6 is a circuit diagram illustrating an example of a pixel block formed in the pixel region of FIG. 1 based on some implementations of the disclosed technology.
FIG. 7 is a plan view illustrating an example of the actual layout of the circuit elements of FIG. 6 within the pixel block based on some implementations of the disclosed technology.

### DETAILED DESCRIPTION

This patent document provides implementations and examples of an image sensing device that may be used to substantially address one or more technical or engineering issues and mitigate limitations or disadvantages encountered in some other image sensing devices. Some implementations of the disclosed technology suggest examples of an image sensing device that can widely expand the operating range of a unit pixel. In recognition of the issues above, the disclosed technology provides various implementations of the image sensing device that can widely expand the operating range of the unit pixel.

Reference will now be made in detail to certain embodiments, examples of which are illustrated in the accompanying drawings. Wherever possible, the same reference numbers will be used throughout the drawings to refer to the same or similar parts. In the following description, a detailed description of related known configurations or functions incorporated herein will be omitted to avoid obscuring the subject matter.

Hereinafter, various embodiments will be described with reference to the accompanying drawings. However, it should be understood that the disclosed technology is not limited to specific embodiments, but includes various modifications, equivalents and/or alternatives of the embodiments. The embodiments of the disclosed technology may provide a variety of effects capable of being directly or indirectly recognized through the disclosed technology.

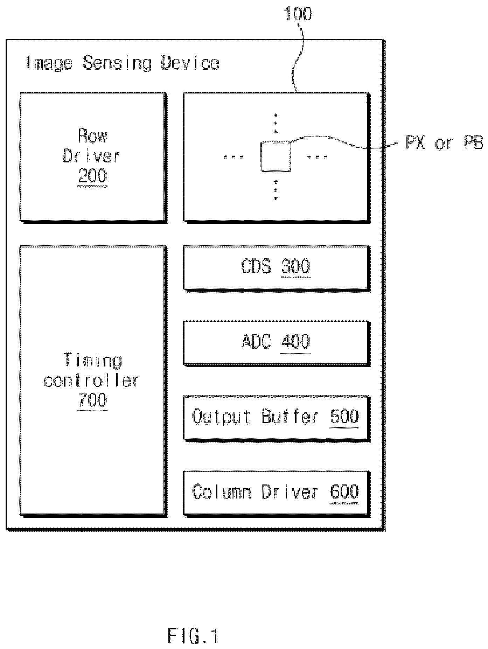

FIG. 1 is a block diagram illustrating an example of an image sensing device based on some implementations of the disclosed technology.

Referring to FIG. 1, the image sensing device may include a pixel region 100, a row driver 200, a correlated double sampler (CDS) 300, an analog-to-digital converter (ADC) 400, an output buffer 500, a column driver 600, and a timing controller 700. The components of the image sensing device illustrated in FIG. 1 are discussed by way of example only, and this patent document encompasses numerous other changes, substitutions, variations, alterations, and modifications. In this patent document, the word "pixel" can be used to indicate an image sensing pixel that is structured to detect incident light to generate electrical signals carrying images in the incident light.

The pixel region 100 may include a plurality of unit pixels (PXs) consecutively arranged in rows and columns. The unit pixels (PXs) may be connected to the row driver 200 through a plurality of row lines, and may be connected to the correlated double sampler (CDS) 300 through a plurality of column lines. Each unit pixel (PX) may convert incident light into an electrical signal to generate a pixel signal, and may output the pixel signal to the correlated double sampler (CDS) 300 through column lines. The pixel transistors of the unit pixels (PXs) may be operated by receiving control signals such as a transfer signal, a reset signal, a switching signal, and a selection signal from the row driver 200.

The pixel region 100 may include a plurality of unit pixel blocks (PBs) consecutively arranged in a matrix including columns and rows. Each unit pixel block (PB) may include a plurality of unit pixels configured to share floating diffusion nodes (FD) and pixel transistors with each other. For example, the unit pixel block (PB) may be formed as an 8-shared pixel structure in which 8 unit pixels share pixel transistors and one single floating diffusion node (FD) is formed for every four unit pixels. At this time, the two floating diffusion nodes (FD) of each pixel block (PB) may be connected to each other through a conductive line to form one common node.

The row driver 200 may activate the pixel region 100 to perform certain operations on the unit pixels in the corresponding row based on control signals provided by controller circuitry such as the timing controller 700. In some implementations, the row driver 200 may select one or more pixel groups arranged in one or more rows of the pixel region 100. The row driver 200 may generate a row selection signal to select one or more rows from among the plurality of rows. The row driver 200 may sequentially enable the reset signal and the transfer signal for the unit pixels arranged in the selected row. The pixel signals generated by the unit pixels arranged in the selected row may be output to the correlated double sampler (CDS) 300.

The correlated double sampler (CDS) 300 may remove undesired offset values of the unit pixels using correlated double sampling. In one example, the correlated double sampler (CDS) 300 may remove the undesired offset values of the unit pixels by comparing output voltages of pixel signals (of the unit pixels) obtained before and after photocharges generated by incident light are accumulated in the sensing node (e.g., a floating diffusion (FD) node). As a result, the CDS 300 may obtain a pixel signal generated only by the incident light without causing noise. In some implementations, upon receiving a clock signal from the timing controller 700, the CDS 300 may sequentially sample and hold voltage levels of the reference signal and the pixel signal, which are provided to each of a plurality of column lines from the pixel region 100. That is, the CDS 300 may sample and hold the voltage levels of the reference signal and the pixel signal which correspond to each of the columns of the pixel region 100. In some implementations, the CDS 300 may transfer the reference signal and the pixel signal of each of the columns as a correlate double sampling (CDS) signal to the ADC 400 based on control signals from the timing controller 700.

The ADC 400 is used to convert analog CDS signals received from the CDS 300 into digital signals. In some implementations, the ADC 400 may be implemented as a ramp-compare type ADC. The analog-to-digital converter (ADC) 400 may compare a ramp signal received from the timing controller 700 with the CDS signal received from the CDS 300, and may thus output a comparison signal indicating the result of comparison between the ramp signal and the CDS signal. The analog-to-digital converter (ADC) 400 may count a level transition time of the comparison signal in response to the ramp signal received from the timing controller 700, and may output a count value indicating the counted level transition time to the output buffer 500.

The output buffer 500 may temporarily store column-based image data provided from the ADC 400 based on control signals of the timing controller 700. The image data received from the ADC 400 may be temporarily stored in the output buffer 500 based on control signals of the timing controller 700. The output buffer 500 may provide an interface to compensate for data rate differences or transmission rate differences between the image sensing device and other devices.

The column driver 600 may select a column of the output buffer 500 upon receiving a control signal from the timing controller 700, and sequentially output the image data, which are temporarily stored in the selected column of the output buffer 500. In some implementations, upon receiving an address signal from the timing controller 700, the column driver 600 may generate a column selection signal based on the address signal, may select a column of the output buffer 500 using the column selection signal, and may control the image data received from the selected column of the output buffer 500 to be output as an output signal.

The timing controller 700 may generate signals for controlling operations of the row driver 200, the ADC 400, the output buffer 500 and the column driver 600. The timing controller 700 may provide the row driver 200, the column driver 600, the ADC 400, and the output buffer 500 with a clock signal required for the operations of the respective components of the image sensing device, a control signal for timing control, and address signals for selecting a row or column. In some implementations, the timing controller 700 may include a logic control circuit, a phase lock loop (PLL) circuit, a timing control circuit, a communication interface circuit and others.

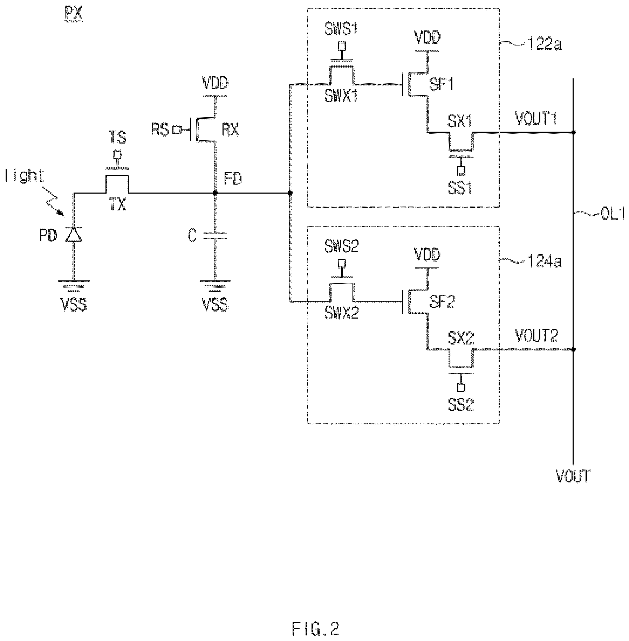

FIG. 2 is a circuit diagram illustrating an example of the unit pixel formed in the pixel region 100 shown in FIG. 1 based on some implementations of the disclosed technology.

Referring to FIG. 2, the unit pixel (PX) may include a photoelectric conversion element (PD), a transfer transistor (TX), a reset transistor (RX), a floating diffusion node (FD), a first pixel signal output unit 122a, and a second pixel signal output unit 124a.

The photoelectric conversion element (PD) may generate and accumulate photocharges corresponding to the light intensity of incident light by converting the incident light. The photoelectric conversion element (PD) may include a photodiode, a phototransistor, a photogate, a pinned photodiode, or a combination thereof.

The transfer transistor (TX) may transmit photocharges (e.g., electrons) generated by the photoelectric conversion element (PD) to the floating diffusion node (FD) based on the transfer signal (TS). The transfer transistor (TX) may be configured to use the photoelectric conversion element (PD) and the floating diffusion node (FD) as source/drain regions of the transfer transistor (TX). The transfer signal (TS) is applied to a gate of the transfer transistor (TX).

The reset transistor (RX) may reset the floating diffusion node (FD) based on the reset signal (RS). The source/drain regions of the reset transistor (RX) may be connected to the power-supply voltage (VDD) and the floating diffusion node (FD), respectively, and the gate of the reset transistor (RX) may be connected to a transmission line through which the reset signal (RS) is transmitted. The reset transistor (RX) may reset the floating diffusion node (FD) to the power-supply voltage (VDD) level when the reset signal (RS) is activated.

The floating diffusion node (FD) may be a diffusion region where photocharges transferred from the photoelectric conversion element (PD) or photocharges corresponding to the reset voltage (e.g., the power-supply voltage VDD) may be accumulated. The floating diffusion node (FD) may be commonly connected to the transfer transistor (TX) and the reset transistor (RX). The floating diffusion node (FD) may be modeled with a unique capacitor (e.g., C) as shown in FIG. 2.

The first pixel signal output unit 122a may be connected to the floating diffusion node (FD) and the pixel signal output line (OL1). In a situation where the floating diffusion node (FD) is reset to a level of the power-supply voltage (VDD) by the reset transistor (RX), the first pixel signal output unit 122a may generate a first pixel signal (VOUT1) based on the voltage of the floating diffusion node (FD) and the first reference voltage, and may output the first pixel signal (VOUT1) to the pixel signal output line (OL1). The first pixel signal output unit 122a may include a first switch transistor (SWX1), a first source follower transistor (SF1), and a first selection transistor (SX1). The first reference voltage may be a first threshold voltage (Vtl) of the first source follower transistor (SF1).

The first switch transistor (SWX1) may selectively connect the gate of the first source follower transistor (SF1) to the floating diffusion node (FD) based on a first switching signal (SWS1). The source/drain regions of the first switch transistor (SWX1) may be respectively connected to the gate of the first source follower transistor (SF1) and the floating diffusion node (FD), and the gate of the first switch transistor (SWX1) may be connected to the transmission line through which the first switching signal (SWS1) is transmitted.

The first source follower transistor (SF1) may have a first threshold voltage (Vt1), and may output a first pixel signal (VOUT1) based on the voltage of the floating diffusion node (FD) and the first threshold voltage (Vtl). For example, the first source follower transistor (SF1) may output the first pixel signal (VOUT1) having the voltage level corresponding to a voltage difference between the first threshold voltage (Vtl) and the voltage of the floating diffusion node (FD). The source/drain regions of the first source follower transistor (SF1) may be respectively connected to the power-supply voltage (VDD) and the source/drain regions of the first selection transistor (SX1), and the gate of the first source follower transistor (SF1) may be connected to the source/drain region of the first switch transistor (SWX1).

The first selection transistor (SX1) may transmit the first pixel signal (VOUT1) output from the first source follower transistor (SF1) to the pixel signal output line (OL1) based on a first selection signal (SS1). The source/drain regions of the first selection transistor (SX1) may be respectively connected to the source/drain regions of the first source follower transistor (SF1) and the pixel signal output line (OL1), and the gate of the first selection transistor (SX1) may be connected to the transmission line through which the first selection signal (SS1) is transmitted.

The second pixel signal output unit 124a may be connected to the floating diffusion node (FD) and the pixel signal output line (OL1) in parallel with the first pixel signal output unit 122a. In a situation where there is a change in a voltage level of the floating diffusion node (FD) due to the photocharges generated in the photoelectric conversion element (PD), the second pixel signal output unit 124a may generate a second pixel signal (VOUT2) based on the floating diffusion node (FD) voltage and the second reference voltage, and may output the second pixel signal (VOUT2) to the pixel signal output line (OL1). The second pixel signal output unit 124a may include a second switch transistor (SWX2), a second source follower transistor (SF2), and a second selection transistor (SX2). The second reference voltage may be the second threshold voltage (Vt2) of the second source follower transistor (SF2).

The second switch transistor (SWX2) may selectively connect the gate of the second source follower transistor (SF2) to the floating diffusion node (FD) based on the second switching signal (SWS2). The source/drain regions of the second switch transistor (SWX2) may be respectively connected to the gate of the second source follower transistor (SF2) and the floating diffusion node (FD), and the gate of the second switch transistor (SWX2) may be connected to the transmission line through which the second switching signal (SWS2) is transmitted.

The second source follower transistor (SF2) may have the second threshold voltage (Vt2), and may output the second pixel signal (VOUT2) based on the floating diffusion node (FD) voltage and the second threshold voltage (Vt2). For example, the second source follower transistor (SF2) may output the second pixel signal (VOUT2) having a voltage level corresponding to a voltage difference between the floating diffusion node (FD) voltage and the second threshold voltage (Vt2). The second threshold voltage (Vt2) of the second source follower transistor (SF2) may be different from the first threshold voltage (Vtl) of the first source follower transistor (SF1). For example, the first threshold voltage (Vtl) may be less than the second threshold voltage (Vt2). The source/drain regions of the second source follower transistor (SF2) may be respectively connected to the power-supply voltage (VDD) and the source/drain regions of the second selection transistor (SX2), and the gate of the second source follower transistor (SF2) may be connected to the source/drain regions of the second switch transistor (SWX2).

The second selection transistor (SX2) may transmit the second pixel signal (VOUT2) output from the second source follower transistor (SF2) to the pixel signal output line (OL1) based on the second selection signal (SS2). The source/drain regions of the second selection transistor (SX2) may be respectively connected to the source/drain regions of the second source follower transistor (SF2) and the pixel signal output line (OL1), and the gate of the second selection transistor (SX2) may be connected to the transmission line through which the second selection signal (SS2) is transmitted.

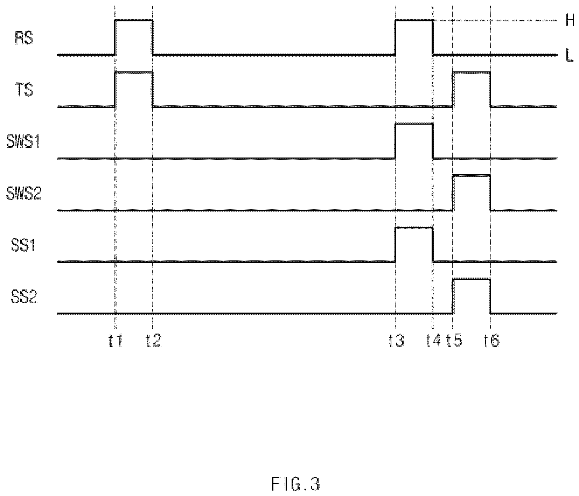

FIG. 3 is a timing diagram illustrating example operations of pixel transistors shown in FIG. 2 based on some implementations of the disclosed technology.

Referring to FIG. 3, control signals (RS, TS, SWS1, SWS2, SS1, SS2) for controlling the operation of the unit pixel described in FIG. 2 are illustrated. These control signals (RS, TS, SWS1, SWS2, SS1, SS2) may be provided from the row driver 200.

Each of the control signals (RS, TS, SWS1, SWS2, SS1, SS2) may have a high level (H) and a low level (L). When a high-level signal (H) is applied to the gates of the transistors (RX, TX, SWX1, SWX2, SX1, SX2) that respectively receive the control signals (RS, TS, SWS1, SWS2, SS1, SS2), the transistors (RX, TX, SWX1, SWX2, SX1, SX2) may be turned on. When a low-level signal (H) is applied to the gates of the transistors (RX, TX, SWX1, SWX2, SX1, SX2), the transistors (RX, TX, SWX1, SWX2, SX1, SX2) may be turned off.

In the present embodiment, an implementation case in which the first threshold voltage (Vtl) of the first source follower transistor (SF1) is smaller than the second threshold voltage (Vt2) of the second source follower transistor (SF2) will hereinafter be described as an example.

First, in a first period (t1 to t2), when the reset signal (RS) and the transfer signal (TS) are activated to a high level (H), the reset transistor (RX) and the transfer transistor (TX) may be turned on to reset the photoelectric conversion element (PD) and the floating diffusion node (FD). For example, photocharges accumulated in the photoelectric conversion element (PD) may be removed, and the floating diffusion node (FD) may transition to the power-supply voltage (VDD) level.

In a second period (t2 to t3), photocharges may be generated in photoelectric conversion element (PD) by incident light, and may be accumulated in the photoelectric conversion element (PD).

In a third period (t3 to t4), the reset signal (RS), the first switching signal (SWS1), and the first selection signal (SS1) may be activated at a high level (H), and the transfer signal (TS), the second switching signal (SWS2) and the second selection signal (SS2) may be deactivated and maintained at a low level (L).

As the reset transistor (RX) and the first switch transistor (SWX1) are turned on by the reset signal (RS) and the first switching signal (SWS1), the floating diffusion node (FD) is reset to the power-supply voltage (VDD) level so that the floating diffusion node (FD) may be connected to the gate of the source follower transistor (SF1). Accordingly, the first source follower transistor (SF1) may output the first pixel signal (VOUT1) corresponding to a voltage difference between the floating diffusion node (FD) voltage and the first threshold voltage (Vtl).

Since the power-supply voltage (VDD) has a predefined specific value, the voltage level of the first pixel signal (VOUT1) output from the first source follower transistor (SF1) may vary depending on the voltage level of the first threshold voltage (Vtl). For example, when the voltage level of the first threshold voltage (Vtl) is sufficiently small, the first source follower transistor (SF1) may increase the first pixel signal (VOUT1) to a signal level close to the power-supply voltage (VDD) level.

The first pixel signal (VOUT1) output from the first source follower transistor (SF1) may be transmitted to the pixel signal output line (OL1) through the first selection transistor (SX1) turned on by the first selection signal (SS1).

In a fourth period (t5 to t6), the reset signal (RS), the first switching signal (SWS1) and the first selection signal (SS1) may be deactivated to a low level (L), and the transfer signal (TS), the second switching signal (SWS2) and the second selection signal (SS2) may be activated to a high level (H). Accordingly, electrical connection between the first pixel signal output unit 122a and the floating diffusion node (FD) may be severed, and the second pixel signal output unit 124a may be electrically connected to the floating diffusion node (FD).

When the transfer transistor (TX) is turned on by the transfer signal (TS), photocharges generated by the photoelectric conversion element (PD) are transmitted to the floating diffusion node (FD), so that the voltage level of the floating diffusion node (FD) may move down to correspond to the amount of such photocharges. In addition, as the second switch transistor (SWX2) is turned on by the second switching signal (SWS2), the floating diffusion node (FD) may be connected to the gate of the second source follower transistor (SF2). Accordingly, the second source follower transistor (SF2) may output the second pixel signal (VOUT2) corresponding to a voltage difference between the floating diffusion node (FD) voltage and the second threshold voltage (Vt2).

Since the power-supply voltage (VDD) has a predefined specific value, the voltage level of the second pixel signal (VOUT2) output from the second source follower transistor (SF2) may vary depending on the voltage level of the second threshold voltage (Vt2). For example, since the second pixel signal (VOUT2) is output in correspondence with the voltage difference between the floating diffusion node (FD) voltage and the second threshold voltage (Vt2), if the second threshold voltage (Vt2) is sufficiently high while the voltage at the floating diffusion node (FD) is lowered by the photocharges, the voltage level of the second pixel signal (VOUT2) may become sufficiently small. For example, the second source follower transistor (SF2) may lower the voltage level of the second pixel signal (VOUT2) to a level close to a ground voltage (VSS) level.

Accordingly, the final pixel signal (VOUT) output through the pixel signal output line (OL1) may range from a maximum value (Vmax) of the first pixel signal (VOUT1), which can be output by the first pixel signal output unit 122a, to a minimum value (Vmin) of the second pixel signal (VOUT2), which can be output by the second pixel signal output unit 124a. In this way, the image sensing device based on some implementations of the disclosed technology can expand the operating range of the unit pixel (PX) by using a plurality of source follower transistors (SF1, SF2) having different threshold voltages.

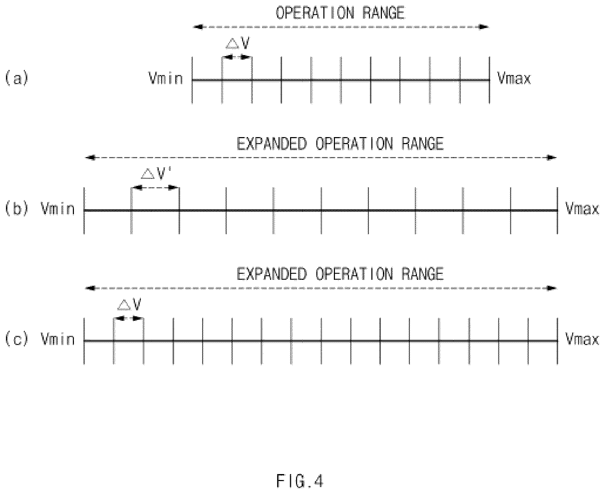

FIG. 4 is a diagram illustrating the effects when the operating range of the unit pixel is expanded operating range based on some implementations of the disclosed technology.

FIG. 4(a) is a diagram illustrating the operating range of the unit pixel based on an example implementation when only one source follower transistor is used. FIGS. 4(b) and 4(c) illustrate expanded operating ranges when two source follower transistors having different threshold voltages are used based on some embodiments of the disclosed technology.

As shown in FIG. 4(b), in a situation where the operating range (Vmax-Vmin) of the unit pixel is expanded, if the expanded operating range is divided into the same number of bits (e.g., 10 bits) as in the example implementation of FIG. 4(a), the voltage corresponding to each bit may increase, thereby reducing the number of bit errors.

Additionally, as shown in FIG. 4(c), when the operating range is divided into the same bit size (ΔV) as in the example implementation of FIG. 4(a), the number of bits can be increased, thereby increasing the resolution of the image sensing device.

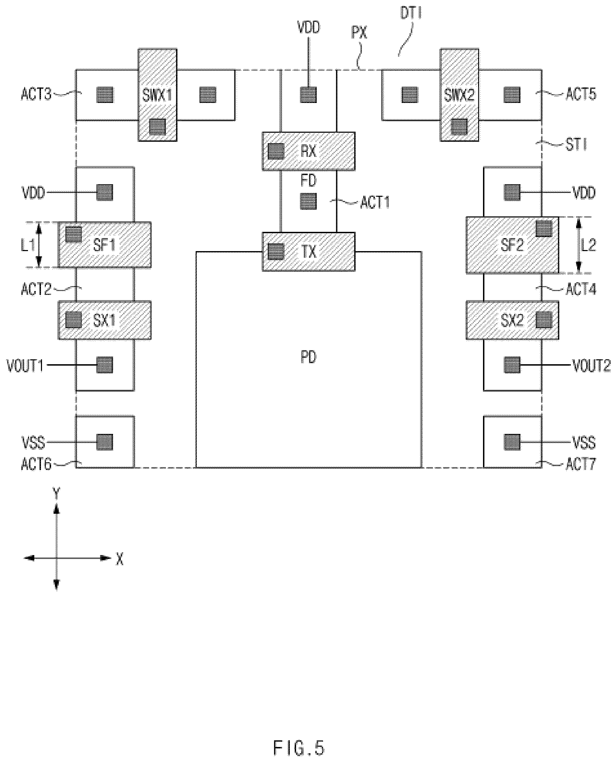

FIG. 5 is a plan view illustrating an example of the actual layout of the circuit elements of FIG. 2 within the unit pixel based on some implementations of the disclosed technology.

Referring to FIG. 5, reference numbers (TX, RX, SWX1, SWX2, SF1, SF2, SX1, SX2) for pixel transistors are indicated on the gates of the corresponding transistors. In FIG. 4, each of black rectangular regions may indicate contacts.

The unit pixel (PX) region may be defined by a pixel isolation structure (DTI). In some implementations, the pixel isolation structure (DTI) may include a trench isolation structure in which an insulation material is embedded in a trench formed by etching the semiconductor substrate to a substantial depth in the semiconductor substrate.

The photoelectric conversion element (PD), the transfer transistor (TX), and the reset transistor (RX) may be sequentially arranged in the second direction (e.g., Y-axis direction) at the center of the unit pixel (PX). The transfer transistor (TX) may be a transistor that uses the photoelectric conversion element (PD) and the floating diffusion node (FD) as its source/drain regions.

The transfer transistor (TX) and the reset transistor (RX) may be formed together in one active region (ACT1) extending in the second direction. The floating diffusion node (FD) may be disposed between the gate of the transfer transistor (TX) and the gate of the reset transistor (RX) in the active region (ACT1). In the active region (ACT1), one region of the gate of the reset transistor (RX) may be connected to the power-supply voltage (VDD) through a contact and a conductive line.

The first source follower transistor (SF1) and the second source follower transistor (SF2) may be symmetrically positioned on two opposite sides of the transfer transistor (TX) in the first direction (e.g., X-axis direction), respectively. For example, the first source follower transistor (SF1) and the second source follower transistor (SF2) may be disposed at both ends of the unit pixel (PX), contacting a pixel isolation structure (DTI). The first source follower transistor (SF1) and the second source follower transistor (SF2) may be formed to have different gate sizes. For example, a gate length (L1) of the first source follower transistor (SF1) may be shorter than a gate length L2 of the second source follower transistor (SF2).

The first selection transistor (SX1) and the second selection transistor (SX2) may also be symmetrically positioned on two opposite sides of the transfer transistor (TX) in the first direction (e.g., X-axis direction), respectively. For example, the first selection transistor (SX1) and the second selection transistor (SX2) may be disposed at both ends of the unit pixel (PX), contacting the pixel isolation structure (DTI). The first selection transistor (SX1) and the second selection transistor (SX2) may be formed to have the same size.

The first source follower transistor (SF1) and the first selection transistor (SX1) may be connected in series in one active region (ACT2) extending in the second direction, and the second source follower transistor (SF2) and the second selection transistor (SX2) may be connected in series in one active region (ACT4) extending in the second direction. Both ends of each of the active regions (ACT2, ACT4) may be connected to the power-supply voltage (VDD) and the pixel signal output line (OL1) through contacts and conductive lines, respectively.

The first switch transistor (SWX1) and the second switch transistor (SWX2) may be symmetrically positioned on two opposite sides of the reset transistor (RX) in the first direction, respectively. For example, the first switch transistor (SWX1) and the second switch transistor (SWX2) may be located at the end of the unit pixel (PX), contacting the pixel isolation structure (DTI). The first switch transistor (SWX1) and the second switch transistor (SWX2) may be formed to have the same size.

The first switch transistor (SWX1) may be formed in the active region (ACT3) extending in the first direction, and the second switch transistor (SWX2) may be formed in the active region (ACT5) extending in the first direction. Both ends of the active region (ACT3) may be connected to the gate of the first source follower transistor (SF1) and the floating diffusion node (FD) through contacts and conductive lines, respectively. Both ends of the active region (ACT5) may be connected to the gate of the second source follower transistor (SF2) and the floating diffusion node (FD) through contacts and conductive lines, respectively.

The active region (ACT6) for supplying the ground voltage (VSS) to the semiconductor substrate may be formed on one side of the active region (ACT2) arranged in the second direction, and the active region (ACT7) for supplying the ground voltage (VSS) to the semiconductor substrate may be formed on one side of the active region (ACT4) arranged in the second direction.

The active regions (ACT1-ACT7) may be isolated from each other by a device isolation structure (STI). For example, the device isolation structure (STI) may include a trench isolation structure in which an insulation material is embedded in a trench formed by etching the semiconductor substrate to a shallow depth.

The pixel transistors (RX, TX, SWX1, SWX2, SF1, SF2, SX1, SX2) and the floating diffusion node (FD) of FIG. 5 may be electrically connected to each other as shown in FIG. 2 through contacts and conductive lines. As long as the electrical connections, as shown in FIG. 2, can be achieved, the formation positions and structures of the contacts and conductive lines are not limited.

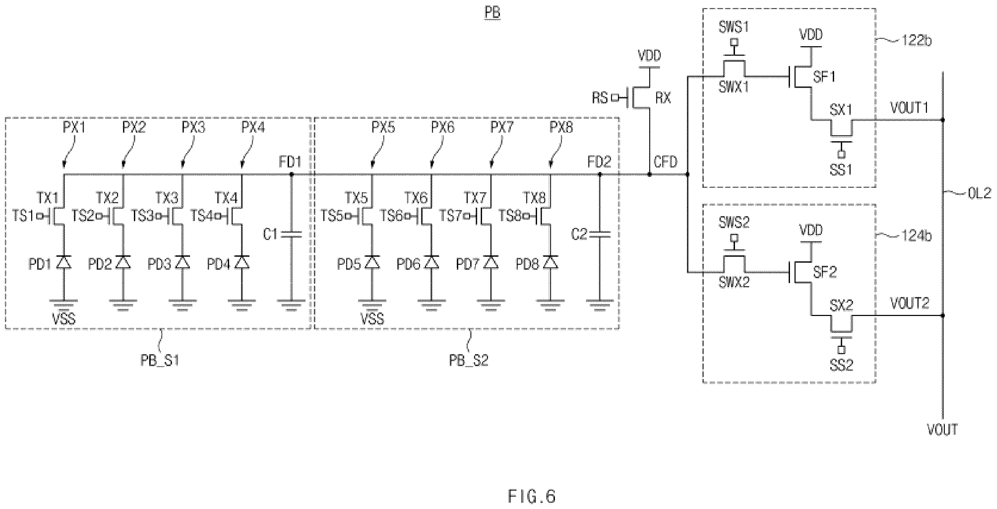

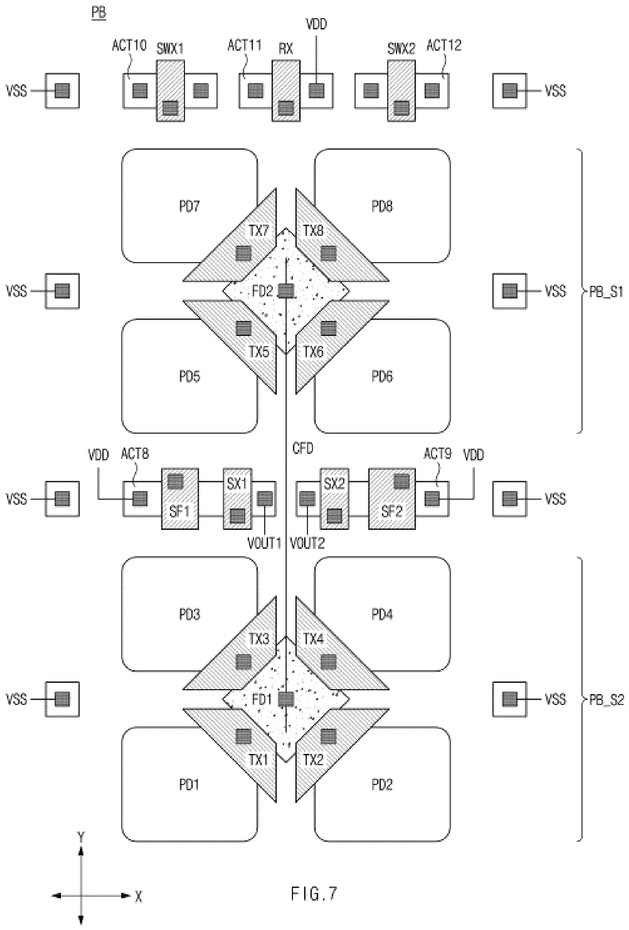

FIG. 6 is a circuit diagram illustrating an example of a pixel block (PB) formed in the pixel region of FIG. 1 based on some implementations of the disclosed technology. FIG. 7 is a plan view illustrating an example of the actual layout of the circuit elements of FIG. 6 within the pixel block (PB) based on some implementations of the disclosed technology.

Referring to FIGS. 6 and 7, the pixel block (PB) may include unit pixels (PX1-PX8), floating diffusion nodes (FD1, FD2), a reset transistor (RX), and a first pixel signal output unit 122b, and a second pixel signal output unit 124b.

Each of the unit pixels (PX1-PX8) may include a single photoelectric conversion element (PD1-PD8) for generating and accumulating photocharges in response to incident light, and a single transfer transistor (TX1-TX8) for transmitting the photocharges generated by the single photoelectric conversion element (PD1-PD8) to a corresponding floating diffusion node (FD1, FD2). In some implementations, the unit pixel (PX1) may include a single photoelectric conversion element (PD1) and a single transfer transistor (TX1) for transmitting photocharges generated by the photoelectric conversion element (PD1) to the corresponding floating diffusion node (FD1), the unit pixel (PX2) may include a single photoelectric conversion element (PD2) and a single transfer transistor (TX2) for transmitting photocharges generated by the photoelectric conversion element (PD2) to the corresponding floating diffusion node (FD1), the unit pixel (PX3) may include a single photoelectric conversion element (PD3) and a single transfer transistor (TX3) for transmitting photocharges generated by the photoelectric conversion element (PD3) to the corresponding floating diffusion node (FD1), and the unit pixel (PX4) may include a single photoelectric conversion element (PD4) and a single transfer transistor (TX4) for transmitting photocharges generated by the photoelectric conversion element (PD4) to the corresponding floating diffusion node (FD1). In addition, the unit pixel (PX5) may include a single photoelectric conversion element (PD5) and a single transfer transistor (TX5) for transmitting photocharges generated by the photoelectric conversion element (PD5) to the corresponding floating diffusion node (FD2), the unit pixel (PX6) may include a single photoelectric conversion element (PD6) and a single transfer transistor (TX6) for transmitting photocharges generated by the photoelectric conversion element (PD6) to the corresponding floating diffusion node (FD2), the unit pixel (PX7) may include a single photoelectric conversion element (PD7) and a single transfer transistor (TX7) for transmitting photocharges generated by the photoelectric conversion element (PD7) to the corresponding floating diffusion node (FD2), and the unit pixel (PX8) may include a single photoelectric conversion element (PD8) and a single transfer transistor (TX8) for transmitting photocharges generated by the photoelectric conversion element (PD8) to the corresponding floating diffusion node (FD2).

The transfer transistors (TX1-TX8) may transmit photocharges accumulated in the corresponding photoelectric conversion elements (PD1-PD8) to the corresponding floating diffusion nodes (FD1, FD2) based on the transfer signals (TS1-TS8). In some implementations, the transfer transistor (TX1) may transmit photocharges accumulated in the photoelectric conversion element (PD1) to the corresponding floating diffusion node (FD1) based on the transfer signal (TS1), the transfer transistor (TX2) may transmit photocharges accumulated in the photoelectric conversion element (PD2) to the corresponding floating diffusion node (FD1) based on the transfer signal (TS2), the transfer transistor (TX3) may transmit photocharges accumulated in the photoelectric conversion element (PD3) to the corresponding floating diffusion node (FD1) based on the transfer signal (TS3), and the transfer transistor (TX4) may transmit photocharges accumulated in the photoelectric conversion element (PD4) to the corresponding floating diffusion node (FD1) based on the transfer signal (TS4). In addition, the transfer transistor (TX5) may transmit photocharges accumulated in the photoelectric conversion element (PD5) to the corresponding floating diffusion node (FD2) based on the transfer signal (TS5), the transfer transistor (TX6) may transmit photocharges accumulated in the photoelectric conversion element (PD6) to the corresponding floating diffusion node (FD2) based on the transfer signal (TS6), the transfer transistor (TX7) may transmit photocharges accumulated in the photoelectric conversion element (PD7) to the corresponding floating diffusion node (FD2) based on the transfer signal (TS7), and the transfer transistor (TX8) may transmit photocharges accumulated in the photoelectric conversion element (PD8) to the corresponding floating diffusion node (FD2) based on the transfer signal (TS8).

The transfer transistors (TX1-TX4) are configured to use the corresponding photoelectric conversion elements (PD1-PD4) and the floating diffusion node (FD1) as its source/drain regions and the transfer signals (TS1-TS4) are applied to the gates of the transfer transistors (TX1-TX4). The transfer transistors (TX5-TX8) are configured to use the corresponding photoelectric conversion elements (PD5-PD8) and the floating diffusion node (FD2) as source/drain regions thereof and the transfer signals (TS5-TS8) are applied to the gates of the transfer transistors (TX5-TX8). In some implementations, the transfer transistor (TX1) is configured to use the photoelectric conversion element (PD1) and the floating diffusion node (FD1) as its source/drain regions and the transfer signal (TS1) is applied to the gate of the transfer transistor (TX1), the transfer transistor (TX2) is configured to use the photoelectric conversion elements (PD2) and the floating diffusion node (FD1) as its source/drain regions and the transfer signal (TS2) is applied to the gate of the transfer transistor (TX2), the transfer transistor (TX3) is configured to use the photoelectric conversion elements (PD3) and the floating diffusion node (FD1) as its source/drain regions and the transfer signal (TS3) is applied to the gate of the transfer transistor (TX3), and the transfer transistor (TX4) is configured to use the photoelectric conversion elements (PD4) and the floating diffusion node (FD1) as its source/drain regions and the transfer signal (TS4) is applied to the gate of the transfer transistor (TX4). In addition, the transfer transistor (TX5) is configured to use the photoelectric conversion elements (PD5) and the floating diffusion node (FD2) as its source/drain regions and the transfer signal (TS5) is applied to the gate of the transfer transistor (TX5), the transfer transistor (TX6) is configured to use the photoelectric conversion elements (PD6) and the floating diffusion node (FD2) as its source/drain regions and the transfer signal (TS6) is applied to the gate of the transfer transistor (TX6), the transfer transistor (TX7) is configured to use the photoelectric conversion elements (PD7) and the floating diffusion node (FD2) as its source/drain regions and the transfer signal (TS7) is applied to the gate of the transfer transistor (TX7), and the transfer transistor (TX8) is configured to use the photoelectric conversion elements (PD7) and the floating diffusion node (FD2) as its source/drain regions and the transfer signal (TS8) is applied to the gate of the transfer transistor (TX8).

The floating diffusion nodes (FD1, FD2) are diffusion regions that are commonly connected to the corresponding transfer transistors (TX1-TX4, TX5-TX8) and the reset transistor (RX). In some implementations, the floating diffusion node (FD1) is used as a diffusion region that is commonly connected to the transfer transistors (TX1-TX4) and the reset transistor (RX), so that photocharges generated by the photoelectric conversion elements (PD1-PD4) or photocharges corresponding to the reset voltage (e.g., the power-supply voltage VDD) can be accumulated in the floating diffusion node (FD1). In addition, the floating diffusion nodes (FD2) is used as a diffusion region that is commonly connected to the transfer transistors (TX5-TX8) and the reset transistor (RX), so that photocharges generated by the photoelectric conversion elements (PD5-PD8) or photocharges corresponding to the reset voltage (e.g., the power-supply voltage VDD) can be accumulated in the floating diffusion node (FD2). The floating diffusion node (FD1) may be modeled with a unique capacitor (e.g., C1) and the floating diffusion node (FD2) may be modeled with a unique capacitor (e.g., C2), as shown in FIG. 5.

The floating diffusion nodes (FD1, FD2) may be connected to each other through a conductive line to form a common floating diffusion node (CFD). For example, each unit pixel block (PB) may include an 8-shared pixel structure in which two floating diffusion nodes (FD1, FD2) are commonly connected to each other and shared by eight unit pixels (PX1-PX8).

The first pixel signal output unit 122b may be connected to the common floating diffusion node (CFD) and the pixel signal output line (OL2). When each unit pixel (PX) is activated, in a situation where the common floating diffusion node (CFD) is reset to the power-supply voltage (VDD) level by the reset transistor (RX), the first pixel signal output unit 122b may generate a first pixel signal (VOUT1) based on a voltage of the common floating diffusion node (CFD) and a first reference voltage. The generated first pixel signal (VOUT1) may then be output to the pixel signal output line (OL2). The first pixel signal output unit 122b may include a first switch transistor (SWX1), a first source follower transistor (SF1), and a first selection transistor (SX1). The first reference voltage may be a first threshold voltage (Vtl) of the first source follower transistor (SF1).

The configuration and operation principle of the first pixel signal output unit 122b are substantially the same as the first pixel signal output unit 122a of FIG. 2 described above. For example, the first pixel signal output unit 122b may operate in the same manner as in FIG. 3 when the unit pixels (PX1-PX8) are activated, and as such detailed descriptions of the configuration and operation of the first pixel signal output unit 122b will herein be omitted here.

The second pixel signal output unit 124b may be connected to the common floating diffusion node (CFD) and the pixel signal output line (OL2) in parallel with the first pixel signal output unit 122b. When each unit pixel (PX) is activated, in a situation where there is a change in the voltage level of the common floating diffusion node (CFD) due to the photocharges generated by the corresponding photoelectric conversion elements (PD1-PD8), the second pixel signal output unit 124b may generate a second pixel signal (VOUT2) based on a voltage of the common floating diffusion node (CFD) and a second reference voltage. The generated second pixel signal (VOUT2) may then be output to the pixel signal output line (OL2). The second pixel signal output unit 124b may include a second switch transistor (SWX2), a second source follower transistor (SF2), and a second selection transistor (SX2). The second reference voltage may be the second threshold voltage (Vt2) of the second source follower transistor (SF2). The second threshold voltage (Vt2) may be greater than the first threshold voltage (Vtl).

The configuration and operation principle of the second pixel signal output unit 124b are substantially the same as the second pixel signal output unit 124a of FIG. 2 described above. For example, the second pixel signal output unit 124b may operate in the same manner as in FIG. 3 when the unit pixels (PX1-PX8) are activated, and as such detailed descriptions of the configuration and operation of the second pixel signal output unit 124b will herein be omitted here.

The reset transistor (RX) may reset the common floating diffusion node (CFD) based on the reset signal (RS). The source/drain regions of the reset transistor (RX) may be connected to the power-supply voltage (VDD) and the common floating diffusion node (CFD), respectively, and the gate of the reset transistor (RX) may be connected to the transmission line through which the reset signal (RS) is transmitted. The reset transistor (RX) may reset the common floating diffusion node (CFD) to the power-supply voltage (VDD) level when the reset signal (RS) is activated.

The eight unit pixels (PX1-PX8) in the pixel block (PB) may be arranged to share one floating diffusion node (FD) for every four unit pixels. For example, among the eight unit pixels (PX1-PX8), four unit pixels (PX1-PX4) may be arranged around the floating diffusion node (FD1), sharing the floating diffusion node (FD1). Additionally, the remaining four unit pixels (PX5-PX8) may be arranged around the floating diffusion node (FD2), sharing the floating diffusion node (FD2).

Hereinafter, for convenience of description, within the pixel block (PB), four unit pixels share one floating diffusion node, and this shared floating diffusion node and the four unit pixels are grouped into a sub-pixel block (PB_S1), and other four unit pixels share the other floating diffusion node, and this shared floating diffusion node and the other four unit pixels are grouped into a sub-pixel block (PB_S2). For example, the sub-pixel block (PB_S1) may refer to a unit block including the floating diffusion node (FD1) and four unit pixels (PX1-PX4) sharing the floating diffusion node (FD1). Additionally, the sub-pixel block (PB_S2) may refer to a unit block including the floating diffusion node (FD2) and four unit pixels (PX5-PX8) sharing the floating diffusion node (FD2).

Within the pixel block (PB), the sub-pixel blocks (PB_S1, PB_S2) may be arranged to be spaced apart from each other by a predetermined distance in the second direction (e.g., Y-axis direction). The subpixel blocks (PB_S1, PB_S2) may have the same arrangement structure, and may be formed to have the same size.

Between the sub-pixel blocks (PB_S1, PB_S2) along the second direction, the first source follower transistor (SF1), the first selection transistor (SX1), the second source follower transistor (SF2), and the second selection transistor (SX2) may be arranged in a row along the first direction (e.g., X-axis direction). The first source follower transistor (SF1) and the first selection transistor (SX1) may be connected in series in one active region (ACT8) extending in the first direction. The second source follower transistor (SF2) and the second selection transistor (SX2) may be connected in series in one active region (ACT9) extending in the first direction. Both ends of the active regions (ACT8, ACT9) may be connected to the power-supply voltage (VDD) and the pixel signal output line (OL2) through contacts and conductive lines, respectively.

The active regions (ACT8, ACT9) may be located adjacent to each other in the first direction. The first source follower transistor (SF1) and the second source follower transistor (SF2) may be arranged symmetrical to each other in the first direction. The first source follower transistor (SF1) and the second source follower transistor (SF2) may be formed to have different gate sizes. For example, the gate of the first source follower transistor (SF1) may be formed to have a smaller size than the gate of the second source follower transistor (SF2).

The first selection transistor (SX1) and the second selection transistor (SX2) may be arranged symmetrical to each other in the first direction. The first selection transistor (SX1) and the second selection transistor (SX2) may be formed to have the same size.

On the other side of the sub-pixel block (PB_S1) arranged in the second direction, the reset transistor (RX), the first switch transistor (SWX1), and the second switch transistor (SWX2) may be linearly arranged in the first direction. For example, the reset transistor (RX) may be located at the center of the region where the reset transistor (RX), the first switch transistor (SWX1), and the second switch transistor (SWX2) are formed, and the first switch transistor (SWX1) and the second switch transistor (SWX2) may be respectively disposed at two opposite sides of the reset transistor (RX) so as to be symmetrical to each other with respect to the reset transistor (RX).

The first switch transistor (SWX1) may be formed in the active region (ACT10) extending in the first direction, and the second switch transistor (SWX2) may be formed in the active region (ACT12) extending in the first direction. Both ends of the active region (ACT10) may be connected to the gate of the first source follower transistor (SF1) and the common floating diffusion node (CFD) through contacts and conductive lines, respectively. Both ends of the active region (ACT12) may be connected to the gate of the second source follower transistor (SF2) and the common floating diffusion node (CFD) through contacts and conductive lines, respectively.

The reset transistor (RX) may be formed in the active region (ACT11) extending in the first direction, and the gate of the reset transistor (RX) may be connected to the conductive line through which the reset signal (RS) is transmitted. Both ends of the active region (ACT11) may be connected to the power-supply voltage (VDD) and the common floating diffusion node (CFD), respectively.

Active regions for supplying a ground voltage (VSS) to the semiconductor substrate may be formed at both ends of the pixel block (PB).

The pixel transistors (RX, TX1-TX8, SWX1, SWX2, SF1, SF2, SX1, SX2) and the common floating diffusion node (CFD) of FIG. 7 may be electrically connected to each other as shown in FIG. 6 through contacts and conductive lines. As long as the electrical connections, as shown in FIG. 6, can be achieved, the formation positions and structures of the contacts and conductive lines are not limited.

In this way, the image sensing device based on some implementations of the disclosed technology can widely expand the operating range of the unit pixel.

While various embodiments have been described above as specific examples for implementing those embodiments, variations and modifications of those embodiments and other embodiments can be made based on what is disclosed and illustrated in this patent document.

## Claims

1. An image sensing device comprising:
a photoelectric conversion element configured to generate photocharges by converting incident light;
a floating diffusion node located adjacent to the photoelectric conversion element and configured to receive and store the photocharges generated by the photoelectric conversion element;
a transfer transistor coupled to the photoelectric conversion element and floating diffusion node and configured to transfer, in response to a transfer signal, the photocharges generated by the photoelectric conversion element to the floating diffusion node;
a reset transistor coupled to the floating diffusion node and configured to reset the floating diffusion node based on a reset signal;
a first pixel signal output unit coupled to the floating diffusion node and configured to output a first pixel signal based on a first reference voltage and a voltage of the floating diffusion node in response to reset of the floating diffusion node by the reset transistor; and
a second pixel signal output unit coupled to the floating diffusion node and configured to output a second pixel signal based on the voltage of the floating diffusion node and a second reference voltage having a different voltage level from the first reference voltage in response to a change of the voltage of the floating diffusion node due to reception of the photocharges from the photoelectric conversion element.

2. The image sensing device according to claim 1, wherein the first pixel signal output unit includes:
a first switch transistor coupled to the floating diffusion node;
a first source follower transistor including a gate that is coupled to the first switch transistor which is configured to selectively connect the gate of the first source follower transistor to the floating diffusion node based on a first switching signal so that the first source follower transistor is operable to output a signal corresponding to a voltage level of the floating diffusion node; and
a first selection transistor coupled to the first source follower transistor and configured to transmit an output signal of the first source follower transistor to a pixel signal output line based on a first selection signal.

3. The image sensing device according to claim 2, wherein:
the first reference voltage is a threshold voltage of the first source follower transistor.

4. The image sensing device according to claim 2, wherein the second pixel signal output unit includes:
a second switch transistor coupled to the floating diffusion node;
a second source follower transistor including a gate coupled to the second switch transistor which is configured to selectively connect the gate of the second source follower transistor to the floating diffusion node based on a second switching signal so that the second source follower transistor is operable to output a signal corresponding to a voltage level of the floating diffusion node; and
a second selection transistor coupled to the second source follower transistor and configured to transmit an output signal of the second source follower transistor to a pixel signal output line based on a second selection signal.

5. The image sensing device according to claim 4, wherein:
the second reference voltage is a threshold voltage of the second source follower transistor.

6. The image sensing device according to claim 4, wherein:
the second reference voltage is greater than the first reference voltage.

7. The image sensing device according to claim 4, wherein:
the first source follower transistor and the second source follower transistor are respectively located at opposite sides of the transfer transistor in a first direction within a unit pixel region defined by a pixel isolation structure.

8. The image sensing device according to claim 7, wherein:
the first source follower transistor and the second source follower transistor are located at both ends of the unit pixel region, contacting the pixel isolation structure.

9. The image sensing device according to claim 7, wherein:
the first source follower transistor and the first selection transistor are disposed in a first active region extending in a second direction cross to the first direction.

10. The image sensing device according to claim 7, wherein:
the second source follower transistor and the second selection transistor are disposed in a second active region extending in a second direction cross to the first direction.

11. The image sensing device according to claim 7, wherein:
the reset transistor is located on one side of the transfer transistor in a second direction cross to the first direction; and
the first switch transistor and the second switch transistor are respectively located on opposite sides of the reset transistor in the first direction.

12. An image sensing device comprising:
a first sub-pixel block including: a first floating diffusion node; and a plurality of first unit pixels configured to share the first floating diffusion node;
a second sub-pixel block including: a second floating diffusion node connected to the first floating diffusion node to form a common floating diffusion node; and a plurality of second unit pixels configured to share the second floating diffusion node;
a reset transistor coupled to the common floating diffusion node and configured to reset the common floating diffusion node based on a reset signal;
a first pixel signal output unit coupled to the common floating diffusion node and configured to output a first pixel signal based on a first reference voltage and a voltage of the common floating diffusion node, in a situation where the common floating diffusion node is reset by the reset transistor; and
a second pixel signal output unit coupled to the common floating diffusion node and configured to output a second pixel signal based on the voltage of the common floating diffusion node and a second reference voltage having a different voltage level from the first reference voltage, in a situation where the voltage of the common floating diffusion node is altered by photocharges generated by the plurality of first unit pixels or the plurality of second unit pixels.

13. The image sensing device according to claim 12, wherein the first pixel signal output unit includes:
a first source follower transistor configured to output a signal corresponding to a voltage level of the common floating diffusion node;
a first switch transistor configured to selectively connect a gate of the first source follower transistor to the common floating diffusion node based on a first switching signal; and
a first selection transistor configured to transmit an output signal of the first source follower transistor to a pixel signal output line based on a first selection signal.

14. The image sensing device according to claim 13, wherein:
the first reference voltage is a threshold voltage of the first source follower transistor.

15. The image sensing device according to claim 13, wherein the second pixel signal output unit includes:
a second source follower transistor configured to output a signal corresponding to a voltage level of the common floating diffusion node;
a second switch transistor configured to selectively connect a gate of the second source follower transistor to the common floating diffusion node based on a second switching signal; and
a second selection transistor configured to transmit an output signal of the second source follower transistor to a pixel signal output line based on a second selection signal.

16. The image sensing device according to claim 15, wherein:
the second reference voltage is a threshold voltage of the second source follower transistor.

17. The image sensing device according to claim 15, wherein:
the first source follower transistor and the second source follower transistor are disposed between the first sub-pixel block and the second sub-pixel block in a second direction.

18. The image sensing device according to claim 17, wherein:
the first source follower transistor and the second selection transistor are disposed in a first active region extending in a first direction cross to the second direction; and
the second source follower transistor and the second selection transistor are disposed in a second active region extending in the first direction.

19. The image sensing device according to claim 17, wherein:
the reset transistor, the first switch transistor, and the second switch transistor are located on one side of the first sub-pixel block in the second direction.

20. The image sensing device according to claim 19, wherein:
the first switch transistor and the second switch transistor are respectively located at opposite sides of the reset transistor in a first direction cross to the second direction.
